# EUROPEAN PATENT APPLICATION

(11) **EP 4 803 796 A1**
(43) Date of publication of application: **09.09.2026**
(21) Application number: 26154195.7
(22) Date of filing: 26.01.2026
(51) Int. Cl.: F16M 11/10, F16M 13/02, H04N 23/57, G08B 13/196, H04N 23/51, H04N 23/52, E01C 11/22

(54) **DUAL-CHAMBER ELECTRONIC DEVICE**

(30) Priority: 03.03.2025 TW 114107664
(71) Applicant: Liu, Che-An, Taichung City 40848 (TW)
(72) Inventor: Liu, Che-An, Taichung City 40848 (TW)
(74) Representative: Stöckeler, Ferdinand

(57) **Abstract**

A dual-chamber electronic device includes a base unit (1) including a lower chamber member (11) and two first connecting members (14) connected fixedly to the lower chamber member (11), and a mount seat unit (2) including an upper chamber member (21), an upper cap (22) disposed on the upper chamber member (21), and two second connecting members (25) fixedly connected to the upper chamber member (21) and detachably and respectively connected to the two first connecting members (14). The upper chamber member (21) has an upper bottom wall (212) disposed on the base unit (1), and an upper surrounding wall (21) extending from a periphery of the upper bottom wall (212) upwardly. The mount seat unit (2) is operable to move between first and second operating states where the upper bottom wall (212) abuts against and does not abut against the base unit (1), respectively.

## Description

The disclosure relates to an electronic device, and more particularly to a dual-chamber electronic device.

A conventional electronic device, e.g., Taiwanese Invention Patent No. TWI838148B, is disclosed to be mounted in a curbstone. The conventional electronic device includes a control box defining a chamber therein, a cover unit detachably covering the control box, and a camera module disposed in the chamber of the control box.

In order to enable the conventional electronic device to provide additional functions, it is necessary to install additional components in the control box, which results in insufficient space in the control box. Furthermore, the additional components and the camera module disposed in the control box typically have their own maintenance schedules such as preventive maintenance routines or inspection schedules, which increases the frequency of opening the control box. Consequently, the increased frequency of accessing the control box leads to a higher likelihood of water ingress.

### SUMMARY

Therefore, an object of the present disclosure is to provide a dual-chamber electronic device that can alleviate at least one of the drawbacks of the prior art.

According to an aspect of the disclosure, there is provided a dual-chamber electronic device adapted to be mounted to a curbstone according to claim 1.

### BRIEF DESCRIPTION OF THE DRAWINGS

Other features and advantages of the disclosure will become apparent in the following detailed description of the embodiment(s) with reference to the accompanying drawings. It is noted that various features may not be drawn to scale.
FIG. 1 is a perspective view of a dual-chamber electronic device of an embodiment according to the present disclosure mounted to a curbstone.
FIG. 2 is an exploded perspective view of the embodiment.
FIG. 3 is a fragmentary sectional view of the embodiment and the curbstone taken along line III-III in FIG. 1, illustrating a mount seat unit and a base unit of the dual-chamber electronic device of the embodiment and the mount seat unit being in a first operating state.
FIG. 4 is a perspective view of the embodiment, illustrating an upper cap of the mount seat pivoted relative to an upper chamber member of the mount seat.
FIG. 5 is a schematic sectional view of FIG. 4, illustrating the upper cap pivoted relative to an upper surrounding wall of the upper chamber member.
FIG. 6 is a top view of FIG. 4, illustrating the upper cap pivoted relative to the upper surrounding wall.
FIG. 7 is a perspective view of the embodiment, illustrating the mount seat unit pivoted relative to the base unit and being in a second operating state.
FIG. 8 is a sectional view of FIG. 7, illustrating the mount seat unit pivoted relative to a support frame of the base unit.

### DETAILED DESCRIPTION

Before the disclosure is described in greater detail, it should be noted that where considered appropriate, reference numerals or terminal portions of reference numerals have been repeated among the figures to indicate corresponding or analogous elements, which may optionally have similar characteristics.

It should be noted herein that for clarity of description, spatially relative terms such as "top," "bottom," "upper," "lower," "on," "above," "over," "downwardly," "upwardly" and the like may be used throughout the disclosure while making reference to the features as illustrated in the drawings. The features may be oriented differently (e.g., rotated 90 degrees or at other orientations) and the spatially relative terms used herein may be interpreted accordingly.

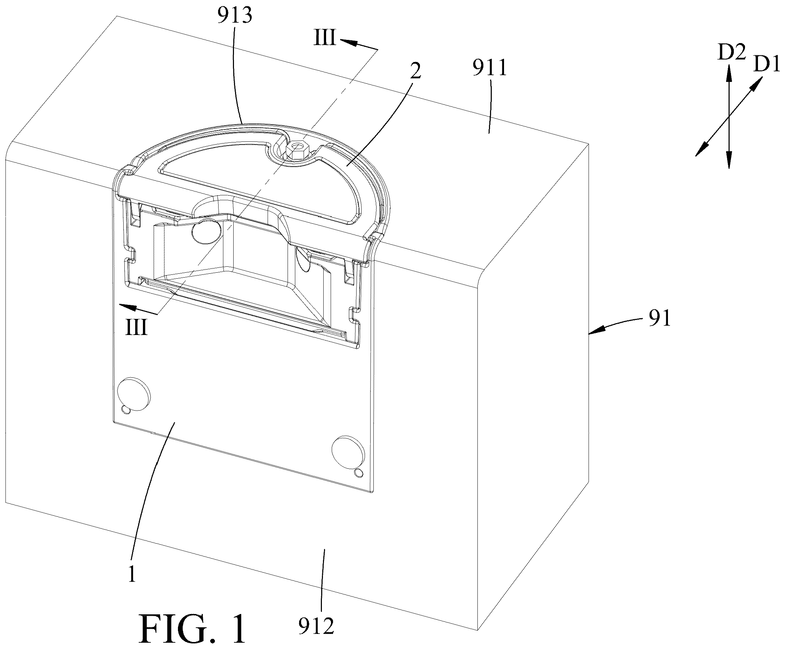

Referring to FIG. 1, a dual-chamber electronic device of an embodiment according to the present disclosure is adapted to be mounted to a curbstone 91. The curbstone 91 has a top stone surface 911 facing upwardly in an up-down direction (D2), a side stone surface 912 connected to a front side of the top stone surface 911 in a front-rear direction (D1) perpendicular to the up-down direction (D2) and facing forwardly in the front-rear direction (D1), and a mounting recess 913 formed at an intersection of the top stone surface 911 and the side stone surface 912.

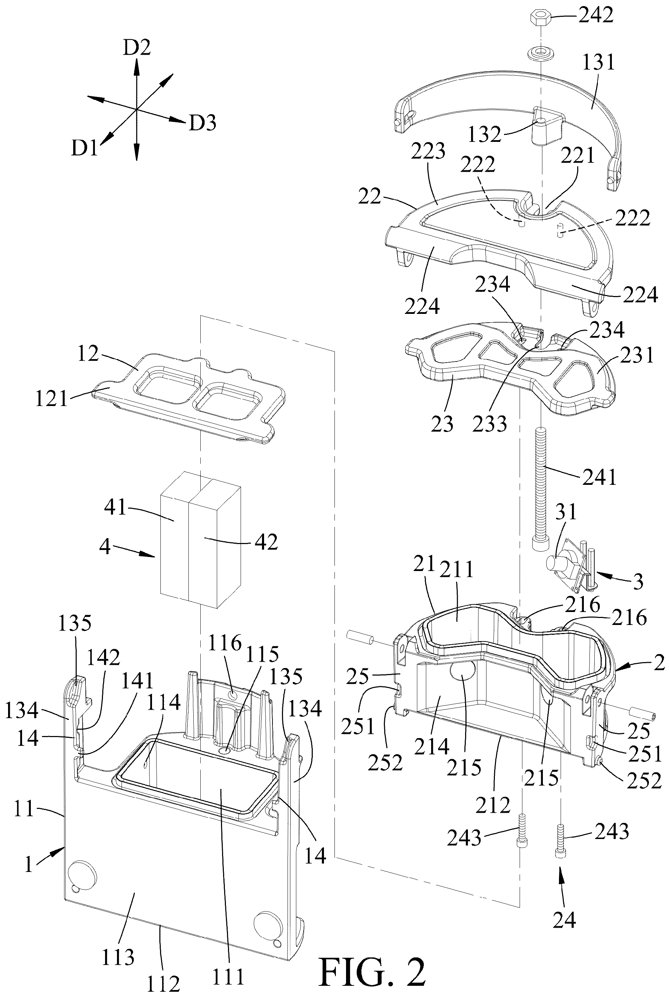

Referring to FIG. 2, the dual-chamber electronic device of the embodiment includes a base unit 1, a mount seat unit 2, an optical unit 3, and an electronic unit 4.

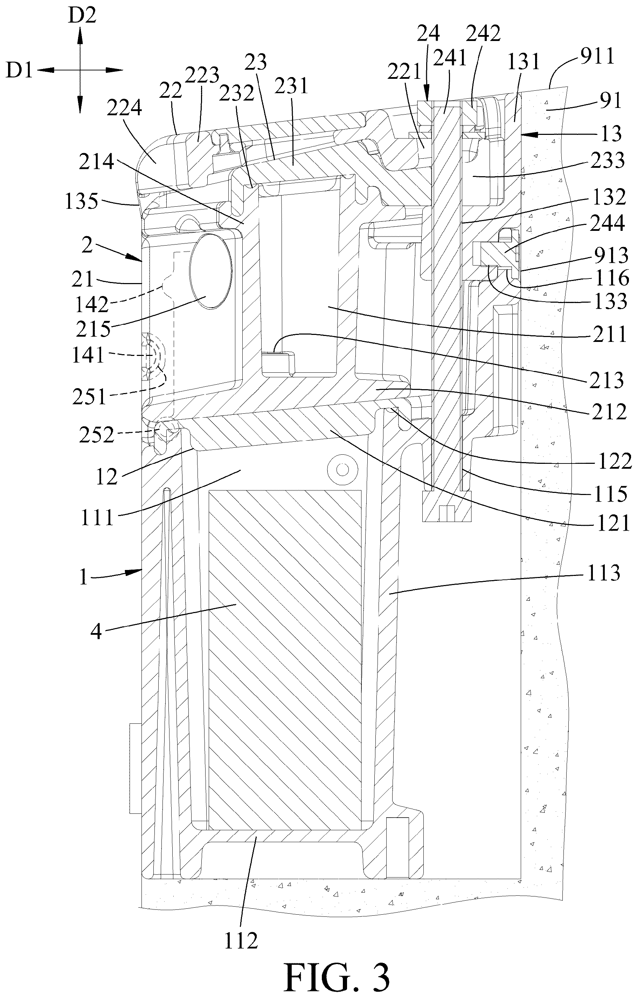

Further referring to FIG. 3, the base unit 1 is adapted to be disposed in the mounting recess 913, and includes a lower chamber member 11, a lower cap 12, a supporting frame 13 (see FIG. 3), and two first connecting members 14. The lower chamber member 11 extends in the up-down direction (D2) and defines a lower chamber 111 that has an opening facing upwardly. The lower cap 12 is disposed on an upper side of the lower chamber member 11 in the up-down direction (D2) and covers the opening of the lower chamber 111. The supporting frame 13 is fixedly connected to the upper side of the lower chamber member 11 in the up-down direction (D2) and correspond in position to the lower cap 12. The two first connecting members 14 are connected fixedly to the lower chamber member 11. In a variation of the embodiment, the lower cap 12 may be omitted and the mount seat unit 2 is disposed on the lower chamber member 11 to cover the opening of the lower chamber 111.

The lower chamber member 11 has a lower bottom wall 112, and a lower surrounding wall 113 extending upwardly from a periphery of the lower bottom wall 112 in the up-down direction (D2). The lower surrounding wall 113 defines a lower wire hole 114, a lower through hole 115, and a rear through hole 116. The lower chamber 111 accommodates the electronic unit 4 therein.

The lower cap 12 includes a lower cap body 121 and a lower plastic portion 122 fixedly connected to a lower side of the lower cover body 121 in the up-down direction (D2).

The supporting frame 13 has two support arms 134 and a connecting wall 131 mounted to the support arms 134. Each of the support arms 134 is formed with an abutment groove 135. In this embodiment, the connecting wall 131 defines an upper through hole 132 (see FIGS. 2 and 3) corresponding in position to the lower through hole 115 in the up-down direction (D2), and a front through hole 133 (see FIG. 3) corresponding in position to the rear through hole 116 in the front-rear direction (D1). In this embodiment, the connecting wall 131 is detachably mounted to the support arms 134, allowing replacement of another connecting wall 131 that has a different top profile.

The first connecting members 14 are respectively connected to the support arms 134. Each of the first connecting members 14 has a support pivot 141 and an abutment surface 142.

The mount seat unit 2 extends in the up-down direction (D2), is disposed on an upper side of the base unit 1 in the up-down direction (D2), and includes an upper chamber member 21, an upper cap 22, an upper plate 23, a fastener unit 24, and two second connecting members 25. The upper chamber member 21 defines an upper chamber 211. The upper cap 22 is disposed on the upper side of the upper chamber member 21 in the up-down direction (D2). The upper plate 23 is disposed between the upper cap 22 and the upper chamber member 21 in the up-down direction (D2). The fastener unit 24 fastens the upper cap 22, the upper plate 23, the upper chamber member 21, and the supporting frame 13 together. The second connecting member 25 are fixedly connected to the upper chamber member 21 and detachably and respectively connected to the first connecting members 14.

The upper chamber member 21 has an upper bottom wall 212 disposed on an upper side of the base unit 1 in the up-down direction (D2), and an upper surrounding wall 214 extending upwardly from a periphery of the upper bottom wall 212 in the up-down direction (D2).

The upper chamber 211 accommodates the optical unit 3 therein.

The upper bottom wall 212 defines an upper wire hole 213 (see FIG. 3) adjacent to the lower wire hole 114. A wire (not shown) extends through the upper wire hole 213 and the lower wire hole 114 to electrically connect the optical unit 3 and the electronic unit 4.

The upper surrounding wall 214 defines two light transmissive portions 215 that are spaced apart from each other in a left-right direction (D3) transverse to the front-rear direction (D1) and the up-down direction (D2), and two lower holes 216 that extend in the up-down direction (D2) and disposed respectively behind the light transmissive portions 215 in the front-rear direction (D1).

The upper cap 22 is pivotably mounted on the upper surrounding wall 214, is disposed above the upper plate 23 in the up-down direction (D2), and defines a second notch 221 and two upper threaded holes 222 respectively corresponding in position to the lower holes 216 of the upper surrounding wall 214 in the up-down direction (D2). The upper cap 22 includes an upper cap body 223 and two protective portions 224 protruding from a front side of the upper cap body 223 in the front-rear direction (D1) and respectively abutting against the abutment grooves 135 of the support arms 134. By virtue of the structure of the abutment grooves 135 and the protective portions 224, when a vehicle collides with the curbstone 91 and the dual-chamber electronic device of the embodiment of the present disclosure, the upper cap 22 cooperates with the support arms 134 to bear a force component in the up-down direction (D2) applied to dual-chamber electronic device, thereby preventing the optical unit 3 accommodated in the upper chamber 211 from damage. It should be noted that in this embodiment, the upper cap body 223 includes two lugs disposed respectively adjacent to the protective portions 224, the upper surrounding wall 214 is formed with two through holes, and the upper chamber member 21 includes two pins extend respectively through the through holes and respectively through the lugs to allow pivot movement of the upper cap 22 relative to the upper surrounding wall 214. It may be appreciated that the configurations of the upper cap 22 and the upper chamber member 21 may be modified as long as the upper cap 22 is pivotable relative to the upper surrounding wall 214.

The upper plate 23 includes an upper plate body 231 and an upper plastic portion 232 fixedly connected to a lower side of the upper plate body 231 in the up-down direction (D2). The upper plate 23 defines a first notch 233 and two central holes 234 flanking the first notch 233 and extending in the up-down direction (D2). The first notch 233 extends in the up-down direction (D2) and corresponds in position to the lower through hole 115, the upper through hole 132, and the second notch 221 in the up-down direction (D2). Each of the central holes 234 correspond in position to a respective one of the lower holes 216 and a corresponding one of the upper threaded holes 222 in the up-down direction (D2). It should be noted that the connecting wall 131 has a profile substantially matching with a profile of the upper plate 23, when the upper cap 22 is disposed on the upper plate 23, a top surface of the upper cap 22 and a top surface of the connecting wall 131 substantially flush with the top stone surface 911 of the curbstone 91.

It should be noted that, in a modification of the embodiment, the upper plate 23 may be replaced by another upper plate 23 having a different top profile to be disposed on an upper side of the upper surrounding wall 214.

The fastener unit 24 includes a threaded rod 241, a threaded nut 242, two auxiliary threaded rods 243, and a reinforcing screw 244 (see FIG. 3). The threaded rod 241 extends through the lower through hole 115, the first notch 233, the second notch 221, and the upper through hole 132. The threaded nut 242 threadedly engages an upper portion of the threaded rod 241 such that the threaded nut 242 and the threaded rod 241 cooperate to fasten the upper cap 22, the upper plate 23, the upper chamber member 21, the connecting wall 131, and the lower chamber member 11 together. The auxiliary threaded rods 243 extend respectively through the lower holes 216, respectively through the central holes 234, and respectively through the upper threaded holes 222. The reinforcing screw 244 (see FIG. 3) extends in the front-rear direction (D1) through the rear through hole 116 and the front through hole 133. By virtue of the threaded nut 242 and the threaded rod 241, the upper cover 22, the upper plate 23, the upper chamber member 21, the connecting wall 131, and the lower chamber member 11 are securely fastened together. In addition, by virtue of the auxiliary threaded rods 243, the upper cover 22, the upper plate 23, and the upper chamber member 21 are stably secured together. Furthermore, by virtue of the reinforcing screw 244, the lower chamber member 11 and the supporting frame 13 are connected stably together.

Each of the second connecting members 25 has a curved supporting surface 251 engaging the support pivot 141 of a respective one of the first connecting members 14, and an abutment rod 252 connected fixedly to the upper surrounding wall 214.

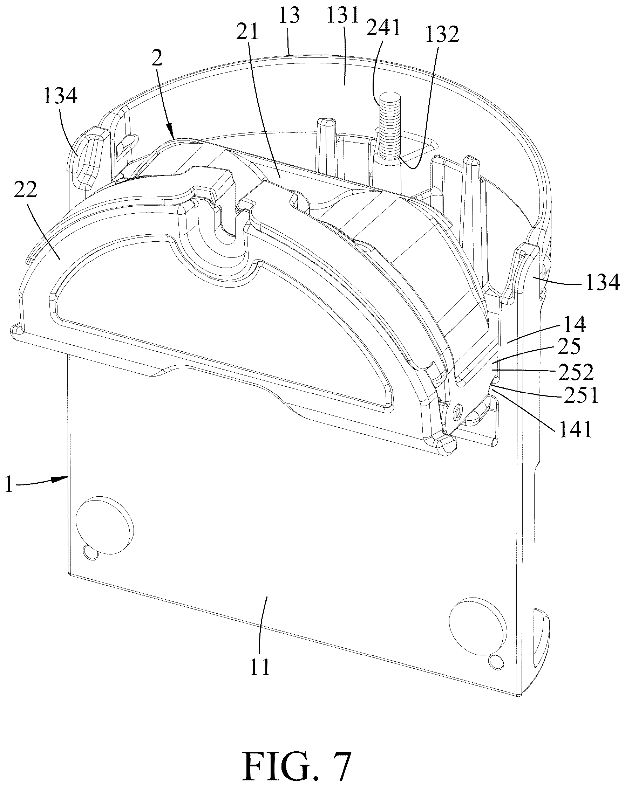

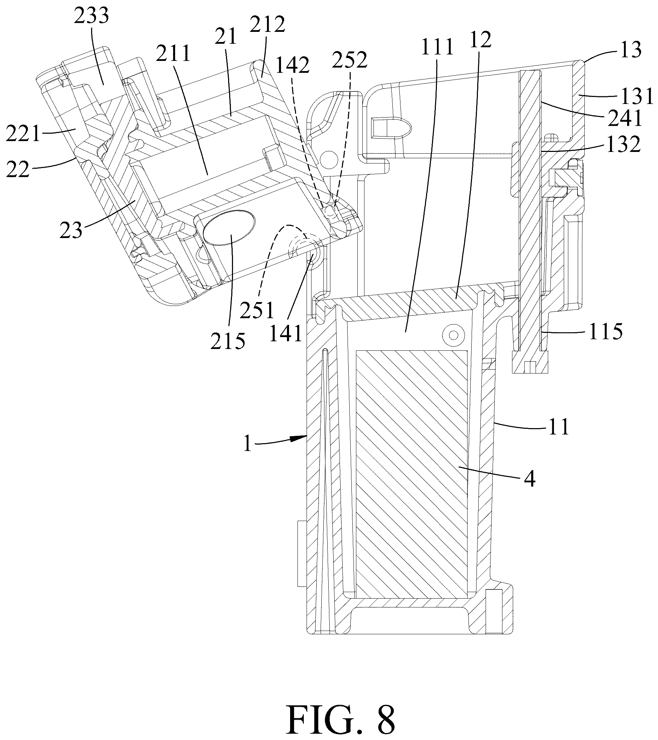

The mount seat unit 2 is operable to move relative to the base unit 1 between a first operating state (see FIG. 3) and a second operating state (see FIGS. 7 and 8). In this embodiment, the upper chamber member 21 of the mount seat unit 2 is pivotable relative to the supporting frame 13 of the base unit 1 between the first operating state and the second operating state through engagement between the curved supporting surface 251 of each of the second connecting members 25 and the support pivot 141 of the respective one of the first connecting members 14. Specifically, the curved supporting surfaces 251 of the second connecting members 25 are respectively rotatable about the support pivots 141 of the first connecting members 14, which serve as pivot pins, so the upper chamber member 21 may be moved between the first operating state and the second operating state relative to the supporting frame 13. When the mount seat unit 2 is in the first operating state, the upper bottom wall 212 of the mount seat unit 2 abuts against and covers the lower cap 12 of the base unit 1, and the abutment rod 252 of each of the second connecting members 25 are away from the abutment surface 142 of the respective one of the first connecting members 14. As shown in FIGS. 7 and 8, when the mount seat unit 2 is in the second operating state, the upper bottom wall 212 of the mount seat unit 2 does not abut against the base unit 1, is away from the lower chamber 111, the lower cap 12 is exposed, and the abutment rods 252 of the second connecting members 25 respectively abut against the abutment surfaces 142 of the first connecting members 14. Thus, by virtue of the curved supporting surfaces 251 and the support pivots 141, the upper chamber member 21 is rotatable relative to the supporting frame 13. Furthermore, by virtue of the abutment rods 252 and the abutment surfaces 142, the rotation of the upper chamber member 21 relative to the supporting frame 13 is limited within a certain range so that the mount seat unit 2 does not separate from the base unit 1.

In a modification of the embodiment (not shown), the second connecting members 25 may include two support pivots and the first connecting members 14 may include two curved supporting surfaces respectively engaging the two support pivots of the second connecting members 25. In this way, the upper chamber member 21 is also rotatable relative to the supporting frame 13 through engagement among the second connecting members 25 and the first connecting members 14. In another modification of the embodiment (not shown), each of the second connecting members 25 has a latch groove, and each of the first connecting members 14 has a block complementary in shape with and engaging the latch groove of the respective one of the second connecting members 25, so the second connecting members 25 may also engage respectively with the first connecting members 14 to allow pivot movement of the upper chamber member 21 relative to the supporting frame 13.

The optical unit 3 is disposed in the upper chamber 211 and includes an image capturing device 31 facing one of the light transmissive portions 215, and a sensing element (not shown) disposed in the upper chamber 211. In this embodiment, the image capturing device 31 is configured to capture an image adjacent to the curbstone 91 through the light transmissive portions 215. The sensing element includes one of an ultrasonic sensor, a thermal sensor, an infrared sensor, a millimeter wave sensor, and a geomagnetic sensor. In a modification of the embodiment, the optical unit 3 further includes a projection lens (not shown) disposed in the upper chamber 211 and facing the other one of the light transmissive portions 215, and the projection lens is configured to project an image through the other one of the light transmissive portions 215 adjacent to the curbstone 91. In another modification of the embodiment, the optical unit 3 includes two of the image capturing devices 31 disposed in the upper chamber 211, respectively facing the light transmissive portions 215, and configured to capture images respectively through the light transmissive portions 215. It should be noted that the image capturing device 31 may include a camera and the present disclosure is not limited to this example.

In this embodiment, the electronic unit 4 is entirely disposed in the lower chamber 111, and includes a battery module 41 and a control module 42 that electrically connects to the battery module 41 and the image capturing device 31. The control module 42 is configured to control the image capturing device 31 to capture images. It should be noted that in other embodiments, the control module 42 of the electronic unit 4 may be disposed in one of the upper chamber 211 and the lower chamber 111. In this embodiment, the control module 42 is implemented by an integrated circuit that includes a machine- or computer-readable storage medium of a memory such as random access memory (RAM), read only memory (ROM), programmable ROM (PROM), firmware, flash memory, etc., a processor such as, but not limited to, a single core processor, a multi-core processor, a dual-core mobile processor, a microprocessor, a microcontroller, a digital signal processor (DSP), a field-programmable gate array (FPGA), an application specific integrated circuit (ASIC), a radio-frequency integrated circuit (RFIC), etc., a communication module, and an input/output interface.

Referring to FIG. 3, by virtue of the fastener unit 24 that fastens the upper cap 22, the upper plate 23, the upper chamber member 21, the connecting wall 131, and the lower chamber member 11 together, the upper plastic portion 232 of the upper plate 23 is pressed against the upper surrounding wall 214 to securely cover the upper chamber 211. Furthermore, the upper bottom wall 212 of the mount seat unit 2 abuts against and covers an upper side of the lower cap 12 in the up-down direction (D2), and the lower plastic portion 122 of the lower cap 12 is pressed against the lower surrounding wall 113 to securely cover the opening of the lower chamber 111.

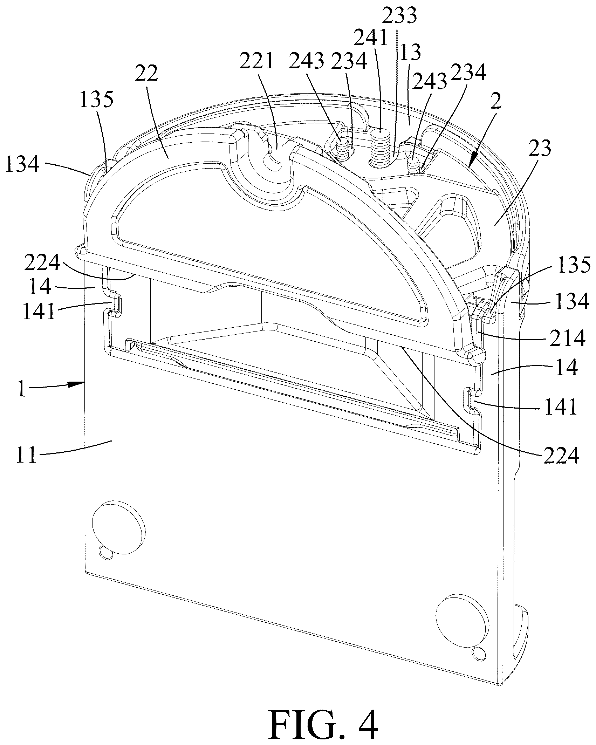

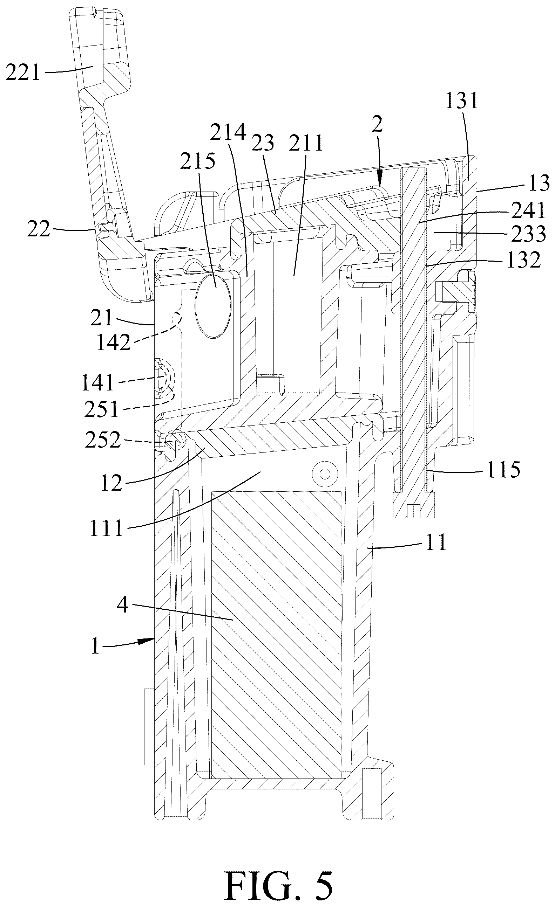

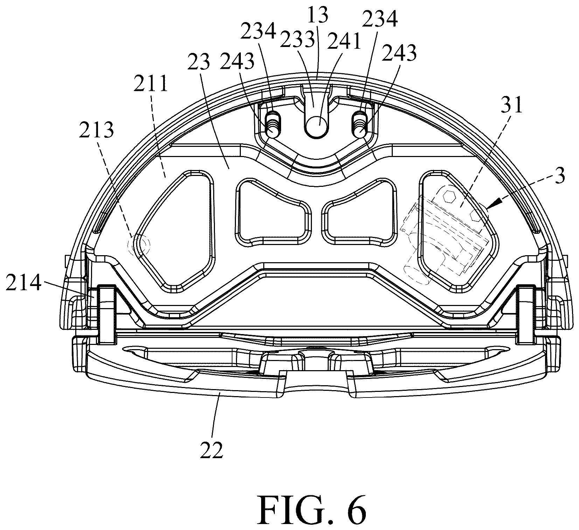

As shown in FIGS. 3 to 6, when it is required to replace the optical unit 3, the threaded nut 242 and the auxiliary threaded rods 243 of the fastener unit 24 are first loosened to allow pivot movement of the upper cap 22 relative to the upper surrounding wall 214, then the upper cap 22 is pivoted to expose the upper plate 23 (see FIGS. 4 to 6), subsequently, the upper plate 23 may be easily removed to replace the optical unit 3 disposed in the upper chamber 211.

Referring to FIGS. 3, and 7 to 8, when it is required to replace the electronic unit 4, the threaded nut 242 of the fastener unit 24 is first loosened to allow pivot movement of the upper chamber member 21 relative to the supporting frame 13 of the lower chamber member 1, then the upper chamber member 21 is pivoted, through engagement among the curved supporting surfaces 251 and the support pivots 141, to expose the lower cap 12, hereafter, the lower cap 12 may be easily removed to replace the electronic unit 4 disposed in the lower chamber 111.

In this way, by virtue of the structures of the curved supporting surfaces 251 of the second connecting members 25 and the support pivots 141 of the first connecting members 14, and the upper cap 22 and the upper chamber member 21, pivot movement of the upper chamber member 21 relative to the supporting frame 13 and pivot movement of the upper cap 22 relative to the upper surrounding wall 214 are allowed, thereby increasing convenience of maintenance of the optical unit 3 and the electronic unit 4 that are respectively disposed in the upper chamber 211 and the lower chamber 111.

In summary, the advantages of the dual-chamber electronic device of the embodiment according to the present disclosure are described below.

First, by virtue of the base unit 1 and the mount seat unit 2 respectively defining the lower chamber 111 and the upper chamber 211, and the structures of the curved supporting surfaces 251 of the second connecting members 25 and the support pivots 141 of the first connecting members 14, and the structures of the upper cap 22 and the upper surrounding wall 214, the upper chamber 211 and the lower chamber 111 may be independently exposed for inspection or replacement of the optical unit 3 and the electronic unit 4 that are respectively disposed therein. Thus, it is relatively convenient to inspect and maintain the components disposed in the upper chamber 211 and the lower chamber 111 of the dual-chamber electronic device of the embodiment according to the present disclosure.

Second, since the profile of the upper plate 23 matches with the profile of the connecting wall 131, when the upper cap 22 is disposed on the upper plate 23, the top surface of the upper cap 22 and the top surface of the connecting wall 131 substantially flush with the top stone surface 911 of the curbstone 91 to provide an aesthetic appearance.

In the description above, for the purposes of explanation, numerous specific details have been set forth in order to provide a thorough understanding of the embodiment(s). It will be apparent, however, to one skilled in the art, that one or more other embodiments may be practiced without some of these specific details. It should also be appreciated that reference throughout this specification to "one embodiment," "an embodiment," an embodiment with an indication of an ordinal number and so forth means that a particular feature, structure, or characteristic may be included in the practice of the disclosure. It should be further appreciated that in the description, various features are sometimes grouped together in a single embodiment, figure, or description thereof for the purpose of streamlining the disclosure and aiding in the understanding of various inventive aspects; such does not mean that every one of these features needs to be practiced with the presence of all the other features. In other words, in any described embodiment, when implementation of one or more features or specific details does not affect implementation of another one or more features or specific details, said one or more features may be singled out and practiced alone without said another one or more features or specific details. It should be further noted that one or more features or specific details from one embodiment may be practiced together with one or more features or specific details from another embodiment, where appropriate, in the practice of the disclosure.

## Claims

1. A dual-chamber electronic device adapted to be mounted to a curbstone (91) that has a top stone surface (911) facing upwardly in an up-down direction (D2), a side stone surface (912) connected to a front side of the top stone surface (911) in a front-rear direction (D1) perpendicular to the up-down direction (D2) and facing forwardly in the front-rear direction (D1), and a mounting recess (913) formed at an intersection of the top stone surface (911) and the side stone surface (912), said dual-chamber electronic device **characterized by**:
a base unit (1) that is adapted to be disposed in the mounting recess (913), that includes a lower chamber member (11) extending in the up-down direction (D2) and defining a lower chamber (111) that has an opening facing upwardly, and two first connecting members (14) connected fixedly to said lower chamber member (11); and
a mount seat unit (2) that extends in the up-down direction (D2), and that includes an upper chamber member (21) defining an upper chamber (211), an upper cap (22) disposed on an upper side of said upper chamber member (21) in the up-down direction (D2), and two second connecting members (25) fixedly connected to said upper chamber member (21),
said upper chamber member (21) having an upper bottom wall (212) that is disposed on an upper side of said base unit (1) in the up-down direction (D2), and an upper surrounding wall (214) that extends from a periphery of said upper bottom wall (212) upwardly in the up-down direction (D2),
said two first connecting members (14) being detachably and respectively connected to said two second connecting members (25), and
said mount seat unit (2) being operable to move relative to said base unit (1) between a first operating state and a second operating state where said upper bottom wall (212) abuts against and does not abut against said base unit (1), respectively.

2. The dual-chamber electronic device as claimed in claim 1, wherein:
said base unit (1) further includes a lower cap (12) disposed on an upper side of said lower chamber member (11) in the up-down direction (D2) and covering said opening of said lower chamber (111);
when said mount seat unit (2) is in the first operating state, said upper bottom wall (212) of said mount seat unit (2) abuts against said lower cap (12) and covering said lower cap (12); and
when said mount seat unit (2) is in the second operating state, said upper bottom wall (212) of said mount seat unit (2) is away from said lower chamber (111), and said lower cap (12) is exposed.

3. The dual-chamber electronic device as claimed in claim 2, wherein:
each of said two second connecting members (25) has an abutment rod (252) connected fixedly to said upper surrounding wall (214);
each of said two first connecting members (14) includes an abutment surface (142);
when said mount seat unit (2) is in the first operating state, said abutment rod (252) of each of said two second connecting members (25) is away from and does not abut against said abutment surface (142) of a respective one of said two first connecting members (14),
when said mount seat unit (2) is in the second operating state, said abutment rod (252) of each of said two second connecting members (25) abuts against said abutment surface (142) of the respective one of said two first connecting members (14).

4. The dual-chamber electronic device as claimed in any one of claims 1 to 3, wherein:
each of said two first connecting members (14) has a support pivot (141);
each of said two second connecting members (25) has a curved supporting surface (251) engaging said support pivot (141) of a respective one of said two first connecting members (14);
said mount seat unit (2) is pivotable relative to said base unit (1) between the first operating state and the second operating state through engagement between said curved supporting surface (251) of each of said two second connecting member (25) and said support pivot (141) of the respective one of said two first connecting members (14).

5. The dual-chamber electronic device as claimed in any one of claims 1 to 4, wherein:
said base unit (1) further includes a supporting frame (13) fixedly connected to an upper side of said lower chamber member (11) in the up-down direction (D2);
said supporting frame (13) has two support arms (134); and
said two first connecting members (14) are respectively connected to said support arms (134).

6. The dual-chamber electronic device as claimed in claim 5, wherein:
said mount seat unit (2) further includes an upper plate (23) disposed between said upper cap (22) and said upper chamber member (21) in the up-down direction (D2);
said upper plate (23) defines a first notch (233) extending in the up-down direction (D2); and
said upper cap (22) is pivotably mounted on said upper surrounding wall (214) and defining a second notch (221) corresponding in position to said first notch (233).

7. The dual-chamber electronic device as claimed in claim 6, wherein:
said lower chamber member (11) has a lower bottom wall (112), and a lower surrounding wall (113) extending upwardly from a periphery of said lower bottom wall (112) in the up-down direction (D2).

8. The dual-chamber electronic device of claim 7, wherein:
said lower surrounding wall (113) defines a lower wire hole (114); and
said upper bottom wall (212) defines an upper wire hole (213) adjacent to said lower wire hole (114).

9. The dual-chamber electronic device as claimed in claim 7 or 8, wherein:
said supporting frame (13) further has a connecting wall (131) mounted to said support arms (134);
said connecting wall (131) defines an upper through hole (132) corresponding in position to said first notch (233); and
said lower surrounding wall (113) defines a lower through hole (115) corresponding in position to said first notch (233) and said upper through hole (132).

10. The dual-chamber electronic device as claimed in claim 9, wherein:
said mount seat unit (2) further includes a fastener unit (24) including a threaded rod (241) extending through said lower through hole (115), said upper through hole (132), said first notch (233), and said second notch (221), and a threaded nut (242) threadedly engaging an upper portion of said threaded rod (241) such that said threaded nut (242) and said threaded rod (241) fasten said upper cap (22), said upper plate (23), said upper chamber member (21), said connecting wall (131), and said lower chamber member (11) together.
